# EUROPÄISCHE PATENTSCHRIFT

(11) **EP 4 012 864 B1**
(45) Veröffentlichungstag und Bekanntmachung des Hinweises auf die Patenterteilung: **01.11.2023**
(21) Anmeldenummer: 20212660.3
(22) Anmeldetag: 09.12.2020
(51) Int. Cl.: H02H 1/00, H02H 7/28

(54) **SCHUTZEINRICHTUNG UND VERFAHREN ZUM ÜBERWACHEN EINES ELEKTRISCHEN ENERGIEVERSORGUNGSNETZES**
SAFETY DEVICE AND METHOD FOR MONITORING AN ELECTRICAL ENERGY SUPPLY NETWORK
DISPOSITIF DE PROTECTION ET PROCÉDÉ DE SURVEILLANCE D'UN RÉSEAU D'ALIMENTATION ÉLECTRIQUE

(43) Veröffentlichungstag der Anmeldung: 15.06.2022
(73) Patentinhaber: Siemens Aktiengesellschaft, 80333 München (DE)
(72) Erfinder: Gaube, Sven, 91448 Emskirchen (DE); Kirkman, Robert, 90518 Altdorf (DE); Jaworski, Michael, 89420 Höchstädt (DE); Klumpp, Philipp, 90403 Nürnberg (DE); Strauß, Martin, 90419 Nürnberg (DE); Jaeger, Johann, 91058 Erlangen (DE); Nöth, Elmar, 91052 Erlangen (DE)
(74) Vertreter: Siemens Patent Attorneys

(56) Entgegenhaltungen:
- EP-A1- 3 460 494
- DE-C1- 19 613 012
- MAHANTY R N ET AL: "Application of RBF neural network to fault classification and location in transmission lines", IEE PROCEEDINGS: GENERATION, TRANSMISSION AND DISTRIBUTION, INSTITUTION OF ELECTRICAL ENGINEERS, GB, Bd. 151, Nr. 2, 2. März 2004 (2004-03-02), Seiten 201-212, XP006021648, ISSN: 1350-2360, DOI: 10.1049/IP-GTD:20040098

## Beschreibung

Die Erfindung betrifft eine Schutzeinrichtung zum Überwachen eines elektrischen Energieversorgungsnetzes, mit einer Messwerterfassungseinrichtung zum Erfassen von Messwerten, die an zumindest einer Messstelle des Energieversorgungsnetzes aufgenommen worden sind und einen elektrischen Zustand des Energieversorgungsnetzes an der Messstelle angeben; und einer Auswerteinrichtung, die mit der Messwerterfassungseinrichtung in Verbindung steht und dazu eingerichtet ist, auf Basis der Messwerte mehrere Schutzfunktionen auszuführen und als Ergebnis der Ausführung der Schutzfunktionen eine Entscheidung zu treffen, ob sich das Energieversorgungsnetz in einem zulässigen oder einem unzulässigen Betriebszustand befindet, wobei die Auswerteinrichtung vollständig in Form eines einzigen neuronalen Netzes ausgebildet ist und eine Eingangs-Neuronen-Schicht, der die Messwerte und/oder davon abgeleitete Werte zugeführt werden, zumindest eine Zwischen-Neuronen-Schicht und eine Ausgangs-Neuronen-Schicht aufweist, die eine Klassifizierung von Betriebszuständen des Energieversorgungsnetzes ausgibt, wobei das neuronale Netz zur Klassifizierung der Betriebszustände dazu trainiert ist, alle Schutzfunktionen gemeinsam auszuführen.

Die Erfindung betrifft auch ein Verfahren zum Überwachen eines elektrischen Energieversorgungsnetzes, bei dem an zumindest einer Messstelle des Energieversorgungsnetzes Messwerte erfasst werden, die einen elektrischen Zustand des Energieversorgungsnetzes an der Messstelle angeben; die Messwerte an eine Schutzeinrichtung übermittelt werden; und auf Basis der Messwerte mittels einer Auswerteinrichtung der Schutzeinrichtung, mehrere Schutzfunktionen ausgeführt werden und als Ergebnis der Ausführung der Schutzfunktionen eine Entscheidung getroffen wird, ob sich das Energieversorgungsnetz in einem zulässigen oder einem unzulässigen Betriebszustand befindet, wobei die Schutzfunktionen mit einer Auswerteinrichtung ausgeführt werden, die vollständig in Form eines einzigen neuronalen Netzes ausgebildet ist und eine Eingangs-Neuronen-Schicht, der die Messwerte und/oder davon abgeleitete Werte zugeführt werden, zumindest eine Zwischen-Neuronen-Schicht und eine Ausgangs-Neuronen-Schicht aufweist, die eine Klassifizierung von Betriebszuständen des Energieversorgungsnetzes ausgibt, aufweist.

Eine solche Schutzeinrichtung und ein solches Verfahren sind aus der EP 3 460 494 A1 bereits bekannt. Die vorbekannte Schutzeinrichtung verfügt über eine Messwerterfassungseinrichtung, die an eine Messstelle eines Energieversorgungsnetztes Messwerte erfasst. Die Messwerterfassungseinrichtung ist mit einer Auswerteeinrichtung verbunden, die auf der Basis der erfassten Messwerte mehrere Schutzfunktionen durchführt und entscheidet, ob sich das Netz in einem zulässigen oder unzulässigen Betriebszustand befindet. Dabei ist die Auswerteeinrichtung in Gestalt eines neuronalen Netzes ausgebildet und umfasst eine Eingangs-, eine Zwischen- und eine Ausgangs-Neuronen-Schicht.

Zur Überwachung von Primärkomponenten elektrischer Energieversorgungsnetze, z.B. Leitungen, Transformatoren, Motoren, Generatoren, werden sogenannte Schutzeinrichtungen eingesetzt, um unzulässige Betriebszustände der jeweils überwachten Primärkomponente, die beispielsweise durch Kurzschlüsse oder Erdschlüsse hervorgerufen sein können, zu erkennen und automatisch abzuschalten. Hierzu nimmt die Schutzeinrichtung üblicherweise an einer oder mehreren Messstellen in dem Energieversorgungsnetz Messwerte auf, beispielsweise Strom- und/oder Spannungsmesswerte, die den Betriebszustand der Primärkomponente charakterisieren. Zur Ausführung seiner Schutzfunktion, wertet die Schutzeinrichtung daraufhin die Messwerte unter Ausführung eines sogenannten Schutzalgorithmus, also einer Berechnungs- und/oder logischen Verknüpfungsvorschrift zur Auswertung der aufgenommenen Messwerte, aus und erzeugt in Abhängigkeit vom Ergebnis der Auswertung gegebenenfalls ein Auslösesignal, das einen mit der Schutzeinrichtung in Verbindung stehenden Leistungsschalter zum Öffnen seiner Schaltkontakte veranlasst, um die fehlerbehaftete Leitung vom übrigen Energieversorgungsnetz abzutrennen.

Wichtig im Zusammenhang mit der Erkennung von Fehlern in Energieversorgungsnetzen ist neben der Frage, ob überhaupt ein Fehler aufgetreten ist, beispielweise auch die Frage nach einer Fehlerart des Fehlers und einem Fehlerort. Eine Fehlerart charakterisiert den vorliegenden Fehler konkreter und gibt beispielsweise an, in welcher möglichen Fehlerschleife des mehrphasigen Energieversorgungsnetzes und/oder in welcher Richtung von der Messstelle aus gesehen der Fehler vorliegt. Bei einem dreiphasigen Energieversorgungsnetz mit drei Leitern (Leiter 1, Leiter 2, Leiter 3) existieren abhängig von den am Fehler beteiligten Leitern sieben mögliche Fehlerschleifen. Ein Fehlerort gibt die fehlerbehaftete Komponente und ggf. einen konkreten Fehlerort (z.B. Abstand bis zum Fehler auf einer Leitung) an. Darüber hinaus können verschiedene Betriebszustände (Ereignisse) des Energieversorgungsnetzes eintreten, die nicht als Fehler erkannt werden dürfen und daher nicht zu einer Auslösung eines Schalters führen sollen. Solche Ereignisse können z.B. eine Inrush-Situation oder eine vorliegende Netzpendelung.

Die Entscheidung, ob ein Betriebszustand zulässig oder unzulässig ist, sowie eine genauere Einstufung eines unzulässigen Betriebszustands (z.B. durch Ereignisklassifikation, Fehlerarterkennung und Fehlerortbestimmung) erreicht eine Schutzeinrichtung durch Ausführung mehrerer Schutzfunktionen, die auf unterschiedliche Analysen spezialisiert sind. Beispielsweise existieren Schutzfunktionen zur Erkennung einer Fehlerart und zur Bestimmung eines Fehlerortes.

In der Netzschutztechnik lassen sich Schutzfunktionen zudem in autonome und koordinative Funktionen unterteilen. Autonome Entscheidungen können von einer Schutzeinrichtung ohne die Berücksichtigung anderer Schutzeinrichtungen in der Umgebung getroffen werden. Beispiele hierfür sind eine Inrusherkennung oder eine Fehlerschleifenauswahl. Koordinative Schutzfunktionen hingegen erfordern die Einbeziehung der umgebenden Schutzeinrichtungen und spiegeln in der Regel Auslöseentscheidungen wider, bei denen das Prinzip der Selektivität gewahrt werden muss.

Aufgrund jüngerer Entwicklungen im Bereich der Energieversorgungsnetze, beispielsweise die Liberalisierung der Stromerzeugungsmärkte und ein damit verbundenes Aufbrechen althergebrachter Stromübertragungsrichtungen im Energieversorgungsnetz durch dezentrale Stromeinspeisung, werden an Schutzeinrichtungen in Energieversorgungsnetzen immer höhere Anforderungen hinsichtlich ihrer Zuverlässigkeit und Selektivität gestellt, so dass eine flexible und adaptive Möglichkeit der Anpassung der jeweils verwendeten Schutzfunktionen zur Erkennung unzulässiger Betriebszustände benötigt wird. Die mittels der Schutzalgorithmen in der Schutzeinrichtung fest implementierte Funktionalität ist nachträglich nicht oder nur in engen Grenzen änderbar. Eine Adaption der Schutzeinrichtung an neue Gegebenheiten des Energieversorgungsnetzes ist nur durch Aufspielen einer neuen Gerätesoftware (Firmware) und eine entsprechende geänderte Konfiguration sowie ggf. durch Veränderung der Geräte-Hardware möglich.

Es ist bekannt, einzelne Schutzfunktionen autonomer Art durch separat trainierte neuronale Netze im Kontext eines Plug&Play Ansatzes zu ersetzen und in den bestehenden Schutzalgorithmus oder die bestehende Schutzlogik einzubetten. Solche Ansätze sind beispielsweise aus der DE 4433406 C1, der WO95/09463 A1, der DE 4333258 A1 und der WO95/09465 A1 bekannt. Bei den bekannten Ansätzen werden jeweils einzelne Schutzfunktionen durch ein speziell trainiertes neuronales Netz ersetzt, es entsteht daher eine Mischung aus Schutzfunktionen, die mittels klassischer Algorithmen ausgeführt werden, und solchen, die mittels eines neuronalen Netzes ausgeführt werden.

Der vorliegenden Erfindung liegt ausgehend von einer Schutzeinrichtung und einem Verfahren der eingangs genannten Art die Aufgabe zugrunde, eine noch schnellere und an unterschiedliche Gegebenheiten des Energieversorgungsnetzes schnell anpassbare Entscheidung darüber treffen zu können, ob ein zulässiger oder ein unzulässiger Betriebszustand vorliegt.

Diese Aufgabe wird durch eine Schutzeinrichtung gemäß des Anspruchs 1 gelöst. Dabei ist zumindest eine der Zwischen-Neuronen-Schichten mit einer Zwischenausgabe-Neuronen-Schicht verbunden , wobei jede Zwischenausgabe-Neuronen-Schicht ein für eine einzelne Schutzfunktion spezifisches Ergebnis ausgibt.

Ein Vorteil der erfindungsgemäßen Schutzeinrichtung besteht darin, dass eine Entscheidung darüber, ob es sich bei einem Betriebszustand des Energieversorgungsnetzes um einen zulässigen oder einen unzulässigen Betriebszustand handelt, vergleichsweise schnell getroffen werden kann, da das neuronale Netz alle Schutzfunktionen gemeinsam ausführt. Im Gegensatz zum bisherigen Ansatz, bei dem lediglich einzelne Schutzfunktionen in einem neuronalen Netz realisiert waren, benötigt die erfindungsgemäße Schutzeinrichtung keinerlei deterministischen Algorithmus mehr, der in Form logischer Schaltungen und/oder Software realisiert ist. Außerdem kommt das neuronale Netz ohne zusätzliche Konfigurationseinstellungen aus und kann sich auch an veränderte Gegebenheiten, z.B. durch verstärkten Netzausbau und dezentrale Einspeisungen, eigenständig anpassen.

Erfindungsgemäß können quasi Zwischenergebnisse der Klassifizierung des Betriebszustands abgegriffen werden. Dies erhöht die Transparenz und damit die Vertrauenswürdigkeit der finalen Entscheidung über den Betriebszustand, da sichtbar ist, auf welchen Einzelentscheidungen die Klassifizierung des Betriebszustands beruht.

Eine weitere vorteilhafte Ausführungsform der erfindungsgemäßen Schutzeinrichtung besteht darin, dass die Schutzfunktionen mindestens eine Klassifizierung eines Ereignisses, eine Erkennung einer Fehlerart und eine Bestimmung eines Fehlerortes umfassen.

Auf diese Weise werden mit dem neuronalen Netz die wesentlichen Entscheidungen getroffen, die eine Klassifizierung eines Betriebszustands betreffen und ggf. eine genaue Einordnung eines Fehlers ermöglichen. Als Ereignisse werden in diesem Zusammenhang beispielsweise ein Kurzschluss, ein Erdschluss, ein Inrushvorgang, eine Lastschaltung und eine Pendelung angesehen. Nicht alle Ereignisse erfordern eine Abschaltung eines Teils des Energieversorgungsnetzes, z.B. sollen bei Inrushvorgängen und gedämpften Pendelungen der Betrieb des Energieversorgungsnetzes aufrechterhalten und eine Abschaltung blockiert werden.

Als Angabe der Fehlerart wird eine Aussage über die fehlerbehaftete Schleife angesehen. Folgende Schleifen können in einem Dreiphasensystem von einem Fehler betroffen sein:

| | |
|---|---|
| Einpoliger Fehler Leiter 1 - Erde: | L1E; |
| Einpoliger Fehler Leiter 2 - Erde: | L2E; |
| Einpoliger Fehler Leiter 3 - Erde: | L3E; |
| Zweipoliger Fehler Leiter 1 - Leiter 2: | L12; |
| Zweipoliger Fehler Leiter 2 - Leiter 3: | L23; |
| Zweipoliger Fehler Leiter 3 - Leiter 1: | L31; |
| Dreipoliger Fehler: | L123. |

Daneben kann bei mehrpoligen Fehlern unterschieden werden, ob diese mit oder ohne Erdberührung auftreten.

Eine Angabe des Fehlerortes kann beispielsweise die Angabe der fehlerbehafteten Primärkomponente, z.B. einer von einem Kurzschluss betroffenen Leitung, beinhalten.

Neben den genannten Schutzfunktionen können weitere Schutzfunktionen hinzutreten, die die Entscheidung über den Betriebszustand des Energieversorgungsnetzes konkretisieren. So kann beispielsweise der Fehlerort durch die Angabe eines Abschnittes auf der fehlerbehafteten Leitung konkretisiert werden, der z.B. in Prozent der Leitungslänge denjenigen Abschnitt angibt, auf dem der Fehler aufgetreten ist (z.B. bis 20% der Leitungslänge). Darüber hinaus können auch sogenannte Trip-Optionen hinzutreten, die eine Angabe über die Funktionsfähigkeit etwaiger an einer Abschaltung beteiligter Leistungsschalter beinhalten (z.B. "alle Schalter intakt", "Leistungsschalter Primärschutz versagt", "Leistungsschalter Sekundärschutz versagt"). Durch diese Informationen kann das neuronale Netz darauf trainiert werden, redundante Schutzkonzepte mit Sekundärschutz bzw. Tertiärschutz anzusteuern.
Die erfindungsgemäße Schutzeinrichtung ist aufgrund der adaptiven Ausgestaltung mit einer Auswerteinrichtung in Form eines neuronalen Netzes höchstgradig skalierbar ausgestaltet. Dies bedeutet, dass sie sowohl in einer dezentralen Schutzarchitektur als auch in einer zentralen Schutzarchitektur und in jeder beliebigen Zwischenstufe eingesetzt werden kann. Die Art der Schutzarchitektur hat Einfluss auf das Training des neuronalen Netzes und ist entsprechend zu berücksichtigen.

Dementsprechend ist gemäß einer vorteilhaften Ausführungsform der erfindungsgemäßen Schutzeinrichtung vorgesehen, dass die Schutzeinrichtung zum lokalen Betrieb an einem Einbauort in der Nähe der Messstelle eingerichtet ist und eine Kommandoeinrichtung zur Ausgabe von Steuerbefehlen an Schalteinrichtungen des Energieversorgungsnetzes aufweist, und dass das neuronale Netz in einem zweistufigen Lernverfahren auf die Klassifizierung von Betriebszuständen des Energieversorgungsnetz trainiert ist.

Hierdurch können eine komplett dezentrale Schutzarchitektur sowie eine teilweise dezentrale Schutzarchitektur ausgestaltet werden. Eine komplett dezentrale Schutzarchitektur umfasst einzelne Schutzeinrichtungen, die in üblicher Weise nah an einer Messstelle angeordnet sind und bei der Überwachung des Energieversorgungsnetzes mit anderen Schutzeinrichtungen interagieren müssen. Bei einer teilweise dezentralen Schutzarchitektur werden weitere Messstellen hinzugenommen, die ebenfalls von der Schutzeinrichtung ausgewertet werden. Die Hinzunahme kann auf z.B. mehrere Abgänge einer Station zusammenfassen oder auf Stations- oder auf Regionenebene erfolgen.

Konkret kann in diesem Zusammenhang vorgesehen sein, dass die Schutzeinrichtung spezifisch auf den Einsatz an ihrem Einbauort trainiert ist.

Damit kann dem unterschiedlichen Verhalten von Messgrößen, wie beispielsweise Strom und Spannung, an verschiedenen Stellen des Energieversorgungsnetzes Rechnung getragen werden.

Eine weitere vorteilhafte Ausführungsform der erfindungsgemäßen Schutzeinrichtung sieht in diesem Zusammenhang vor, dass die Schutzeinrichtung eine Kommunikationsschnittstelle zur Verbindung mit einer übergeordneten Leitstelle aufweist und zum Empfang von Parametern zur Kalibrierung des neuronalen Netzes aufweist.

Obwohl die Schutzeinrichtung bei dezentralem Betrieb aufgrund der flexiblen Anpassung des neuronalen Netzes an unterschiedliche Betriebsszenarien ohne Kommunikation mit anderen Schutzeinrichtungen auskommt, stellt eine solche Kommunikationsschnittstelle eine geeignete Möglichkeit dar, um die Schutzeinrichtung bedarfsweise von der Leitstelle mit geänderten Konfigurationen des neuronalen Netzes zu versehen. Beispielsweise können solche geänderten Konfigurationen Kantengewichte des neuronalen Netzes enthalten, mit denen sich nach einer Topologieänderung des Energieversorgungsnetzes (z.B. aufgrund von Schaltvorgängen und/oder Netzausbau) das Verhalten des neuronalen Netzes an die neue Situation anpassen lässt.

Hinsichtlich des Trainings des neuronalen Netzen beim dezentralen Einsatz kann schließlich vorgesehen sein, dass das neuronale Netz in der ersten Stufe über ein Deep Learning Verfahren trainiert ist und in der zweiten Stufe über ein Reinforcement Learning Verfahren trainiert ist.

Bei dem Deep Learning Verfahren, das bevorzugt mit Backpropagation durchgeführt wird, wird dem neuronalen Netz eine Vielzahl bekannter Verläufe von Messgrößen mit entsprechenden Klassifikationslabels präsentiert. Das neuronale Netz passt sein Verhalten bis zu einer bestimmten Neuronenschicht an die präsentierten Szenarien an. Mittels Reinforcement Learning kann das neuronale Netz ein geeignetes Verhalten bei der Interaktion mit anderen Schutzeinrichtungen erlernen. Dies ist beispielsweise für Redundanzkonzepte mit Haupt- und Reserveschutz, für Staffelpläne beim Schalten und für das Verhalten beim Versagen eines Leistungsschalters vonnöten.

Alternativ zur dezentralen Schutzarchitektur kann auch eine zentrale Schutzarchitektur ermöglicht werden. Die Schutzeinrichtung ist dann in Form einer Datenverarbeitungseinrichtung in einer Leitstelle oder eines Cloudcomputing-Systems ausgebildet und mit Sensoren und Aktoren im Energieversorgungsnetz über geeignete Kommunikationsverbindungen verbunden.

In diesem Zusammenhang sieht eine vorteilhafte Ausführungsform der erfindungsgemäßen Schutzeinrichtung vor, dass die Schutzeinrichtung eine zentrale Schutzeinrichtung ist, die dazu eingerichtet ist, von Sensoren an mehreren Messstellen des Energieversorgungsnetzes Messwerte zu empfangen und Schalteinrichtungen an mehreren Stellen des Energieversorgungsnetzes anzusteuern, und das neuronale Netz über ein einstufiges Lernverfahren auf die Klassifizierung von Betriebszuständen des Energieversorgungsnetz trainiert ist.

Konkret kann in diesem Zusammenhang vorgesehen sein, dass das neuronale Netz über ein Deep Learning Verfahren trainiert ist.

Da im Vergleich zum dezentralen Ansatz bei einer komplett zentralen Schutzarchitektur eine Abstimmung zwischen einzelnen (dezentralen) Schutzeinrichtungen fortfällt, ist ein einstufiges Lernverfahren basierend auf Training mit Deep Learning (vorzugsweise mit Backpropagation) ausreichend.

Die oben genannte Aufgabe wird auch durch ein Verfahren zum Überwachen eines elektrischen Energieversorgungsnetzes der eingangs genannten Art gelöst und ist im Anspruch 9 definiert.

Erfindungsgemäß ist vorgesehen, dass zumindest eine der Zwischen-Neuronen-Schichten mit einer Zwischenausgabe-NeuronenSchicht verbunden ist, die ein für eine einzelne Schutzfunktion spezifisches Ergebnis ausgibt.

Hinsichtlich des erfindungsgemäßen Verfahrens gelten alle zu der erfindungsgemäßen Schutzeinrichtung voranstehend und nachfolgend gemachten Ausführungen und umgekehrt in entsprechender Weise, insbesondere ist die erfindungsgemäße Schutzeinrichtung zur Durchführung des erfindungsgemäßen Verfahrens in jeder beliebigen Ausführungsform oder einer Kombination beliebiger Ausführungsformen eingerichtet. Auch hinsichtlich der Vorteile des erfindungsgemäßen Verfahrens wird auf die zu der erfindungsgemäßen Schutzeinrichtung beschriebenen Vorteile verwiesen.

Eine vorteilhafte Ausführungsform des erfindungsgemäßen Verfahrens sieht vor, dass vor einer Aufnahme der Überwachung des Energieversorgungsnetzes das neuronale Netz zur Klassifizierung der Betriebszustände dazu trainiert wird, alle Schutzfunktionen gemeinsam auszuführen.

Auf diese Weise kann eine Einstufung des aktuellen Betriebszustands des Energieversorgungsnetzes sehr schnell und flexibel an sich ändernde Gegebenheiten anpassbar ausgeführt werden.

Gemäß einer weiteren vorteilhaften Ausführungsform des erfindungsgemäßen Verfahrens kann vorgesehen sein, dass bei einer Schutzeinrichtung, die zum lokalen Betrieb an einem Einbauort in der Nähe der Messstelle eingerichtet ist, das neuronale Netz vor der Aufnahme der Überwachung in einem zweistufigen Lernverfahren auf die Klassifizierung von Betriebszuständen des Energieversorgungsnetz trainiert wird.

Konkret kann in diesem Zusammenhang vorgesehen sein, dass mit der ersten Stufe des Lernverfahrens die Struktur des neuronalen Netzes von der Eingangs-Neuronen-Schicht bis zu einer der Ausgangs-Neuronen-Schicht unmittelbar vorgelagerten Zwischen-Neuronen-Schicht über ein Deep Learning Verfahren trainiert wird, und mit der zweiten Stufe des Lernverfahrens die Struktur des neuronalen Netzes von der der Ausgangs-Neuronen-Schicht unmittelbar vorgelagerten Zwischen-Neuronen-Schicht bis zur Ausgangs-Neuronen-Schicht über ein Reinforcement Learning Verfahren trainiert wird.

Alternativ zum dezentralen Ansatz kann gemäß einer vorteilhaften Ausführungsform des erfindungsgemäßen Verfahrens auch vorgesehen sein, dass bei einer Schutzeinrichtung, die dazu eingerichtet ist, als zentrale Schutzeinrichtung von Sensoren an mehreren Messstellen des Energieversorgungsnetzes Messwerte zu empfangen und Schalteinrichtungen an mehreren Stellen des Energieversorgungsnetzes anzusteuern, das neuronale Netz vor der Aufnahme der Überwachung über ein einstufiges Lernverfahren auf die Klassifizierung von Betriebszuständen des Energieversorgungsnetz trainiert wird.

Die Erfindung wird nachfolgend anhand eines Ausführungsbeispiels näher erläutert. Die spezifische Ausgestaltung des Ausführungsbeispiels ist für die allgemeine Ausgestaltung des erfindungsgemäßen Verfahrens und der erfindungsgemäßen Einrichtung in keiner Weise einschränkend zu verstehen; vielmehr können einzelne Ausgestaltungsmerkmale des Ausführungsbeispiels in beliebiger Weise frei untereinander und mit den voranstehend beschriebenen Merkmalen kombiniert werden.

Hierzu zeigen
- Figur 1: eine schematische Darstellung einer aus dem Stand der Technik bekannten Schutzeinrichtung mit einer Kombination aus einem neuronalen Netz und einer deterministischen Schutzlogik;
- Figur 2: eine schematische Darstellung einer Schutzeinrichtung mit einem neuronalen Netz;
- Figur 3: eine schematische Darstellung eines Energieverteilungsnetzes;
- Figur 4: eine detaillierte Darstellung eines Ausführungsbeispiels einer Auswerteinrichtung einer Schutzeinrichtung;
- Figur 5: eine Baumstruktur zur Erläuterung der von der Auswerteinrichtung aus Figur 4 ausgeführten Schutzfunktionen;
- Figur 6: verschiedene Abstufungen zwischen einer zentralen und einer dezentralen Schutzarchitektur;
- Figur 7: eine schematische Darstellung einer dezentralen Schutzarchitektur; und
- Figur 8: eine schematische Darstellung einer zentralen Schutzarchitektur.

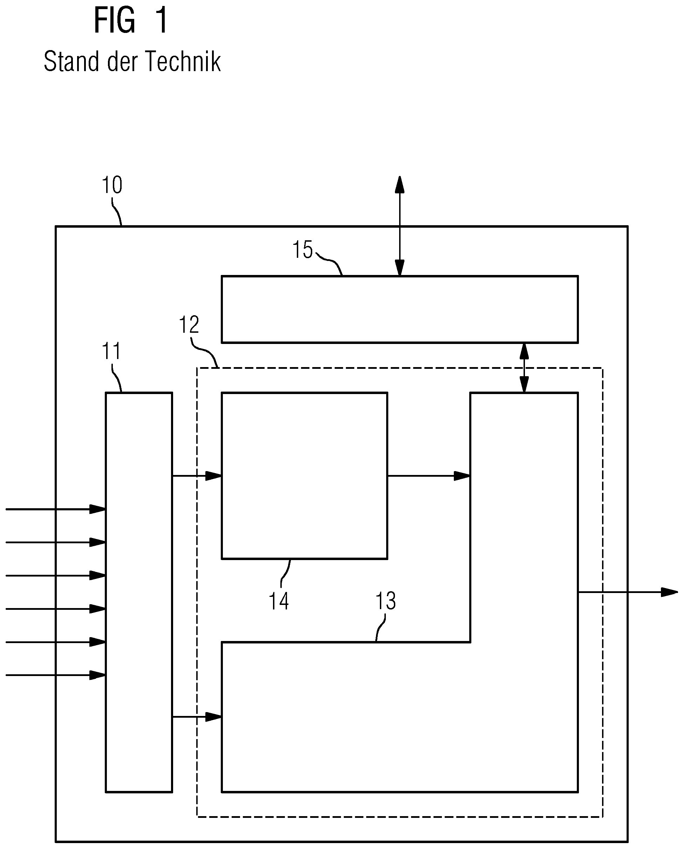

Figur 1 zeigt eine aus dem Stand der Technik bekannte Schutzeinrichtung 10, die zur Überwachung eines in Figur 1 nicht gezeigten elektrischen Energieversorgungsnetzes eingerichtet ist. Die Schutzeinrichtung 10 weist eine Messwerterfassungseinrichtung 11 und eine Auswerteinrichtung 12 auf. Zudem ist eine Kommunikationsschnittstelle 15 zur Kommunikation mit anderen Schutzeinrichtungen sowie ggf. einer übergeordneten Netzleitstelle vorgesehen.

Mittels der Messwerterfassungseinrichtung nimmt die Schutzeinrichtung 10 an einer Messstelle des Energieversorgungsnetzes erfasste Messwerte auf, die den Verlauf von Messgrößen beschreiben, die dazu geeignet sind, den Betriebszustand des Energieversorgungsnetzes an der Messstelle zu charakterisieren. Solche Messgrößen können beispielsweise eine Spannung, ein Stromfluss, eine Frequenz, eine Leistung oder eine Temperatur umfassen. Die Messwerte werden, ggf. nach einer Vorverarbeitung (z.B. Filterung, ggf. Transformation) der Auswerteinrichtung 12 zugeführt, mit der eine Entscheidung über den aktuellen Betriebszustand des Energieversorgungsnetzes getroffen wird. Wird ein unzulässiger Betriebszustand erkannt, der auf einen Fehler zurückzuführen ist, führt die Auswerteinrichtung weitere Schutzfunktionen zur Erkennung der Fehlerart, des Fehlerortes etc. durch und gibt ausgangsseitig ggf. ein Auslösesignal ab, mit dem ein in dem Energieversorgungsnetz vorgesehener Schalter zum Öffnen seiner Schaltkontakte bewegt wird, um einen schädlichen Fehlerstrom zu unterbrechen.

Die Auswerteinrichtung 12 umfasst einerseits eine deterministische Schutzlogik 13, mit der die Schutzfunktionen zur Klassifizierung eines Fehlers durchgeführt werden. Diese Schutzlogik 13 umfasst hierzu üblicherweise eine Kombination aus einem Mikroprozessor und einer von dem Mikroprozessor ausgeführten Software (Firmware). Daneben weist die Auswerteinrichtung 12 ein neuronales Netz 14 auf, das dazu ausgebildet ist, eine einzelne Schutzfunktion, z.B. die Erkennung einer Fehlerart, durchzuführen.

Bei der Schutzeinrichtung 10 kann es sich z.B. um ein Distanzschutzgerät, ein Differentialschutzgerät oder ein Überstromschutzgerät handeln.

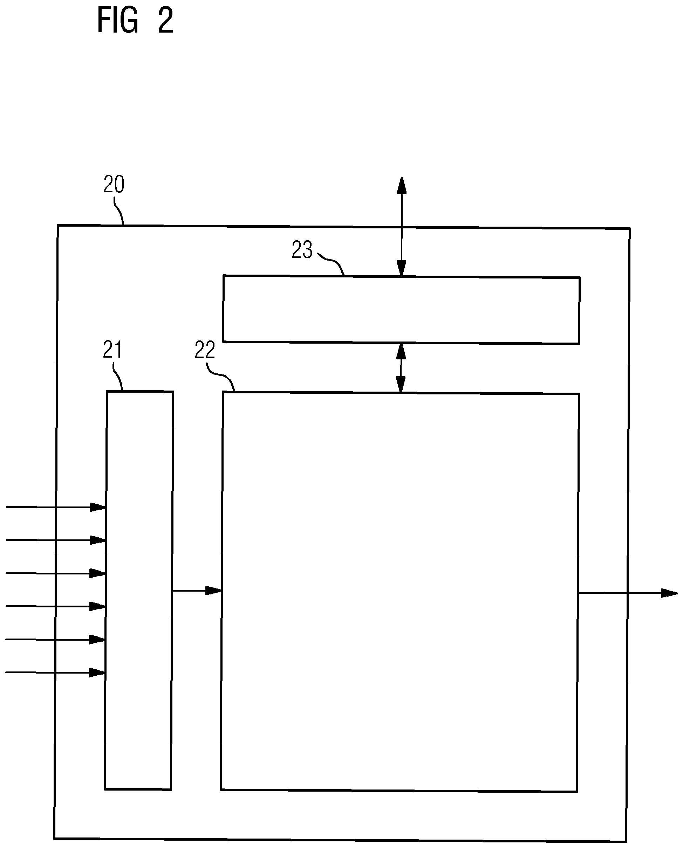

Figur 2 zeigt eine Schutzeinrichtung 20, die ebenfalls eine Messwerterfassungseinrichtung 21 und eine Auswerteinrichtung 22 aufweist. Die Schutzeinrichtung 20 umfasst beim Einsatz in einer dezentralen Schutzarchitektur zudem eine Kommunikationsschnittstelle 23 zur Anbindung an eine übergeordnete Leitstelle. Im Gegensatz zur Schutzeinrichtung 10 der Figur 1 umfasst die Auswerteinrichtung 22 ein einzelnes neuronales Netz, das zur Ausführung aller Schutzfunktionen gemeinsam eingerichtet ist.

Mit der Schutzeinrichtung 20 wird somit das Ziel verfolgt, eine einzige Schutzinstanz durch ein einzelnes gesamtheitlich trainiertes neuronales Netz abzubilden. Dies kann durch eine auf die Anforderungen der Schutztechnik für Energieversorgungsnetze abgestimmten Kombination aus Trainingsprozess und Struktur des neuronalen Netzes erreicht werden. Der Trainingsprozess umfasst je nach gewählter Schutzarchitektur (zentral/dezentral) bis zu zwei Trainingsstufen, die sich jeweils auf bestimmte Bereiche des neuronalen Netzes auswirken.

Eine Besonderheit des mit der Schutzeinrichtung 20 realisierbaren Lösungsansatzes liegt in seiner Skalierbarkeit der Dezentralität bzw. Zentralität. Dadurch sind Ausprägungen von dezentralen Schutzinstanzen bis hin zur zentralen Schutzinstanz und sämtlicher denkbarer Zwischenstufen nach dem gleichen Prinzip zu realisieren; lediglich das Training wird an die jeweils gewählte Situation angepasst.

Bei einer dezentralen Schutzarchitektur spiegelt die erste Trainingsstufe das Erlernen autonomer Entscheidungen wider und kann auf Basis eines Deep Learning Ansatzes mit Backpropagation umgesetzt werden. Diese Trainingsstufe erfordert gelabelte Trainingsdaten, die mit vertretbarem Aufwand generiert werden können. Die zweite Trainingsstufe ist für die koordinativen Entscheidungen vorgesehen. Aufgrund der extrem hohen Variantenvielfalt koordinativer Entscheidungen sind gelabelte Trainingsdaten in diesem Kontext nicht mit vertretbarem Aufwand zu generieren. Daher wird diese Trainingsstufe mit einem Reinforcement Learning Ansatz umgesetzt.

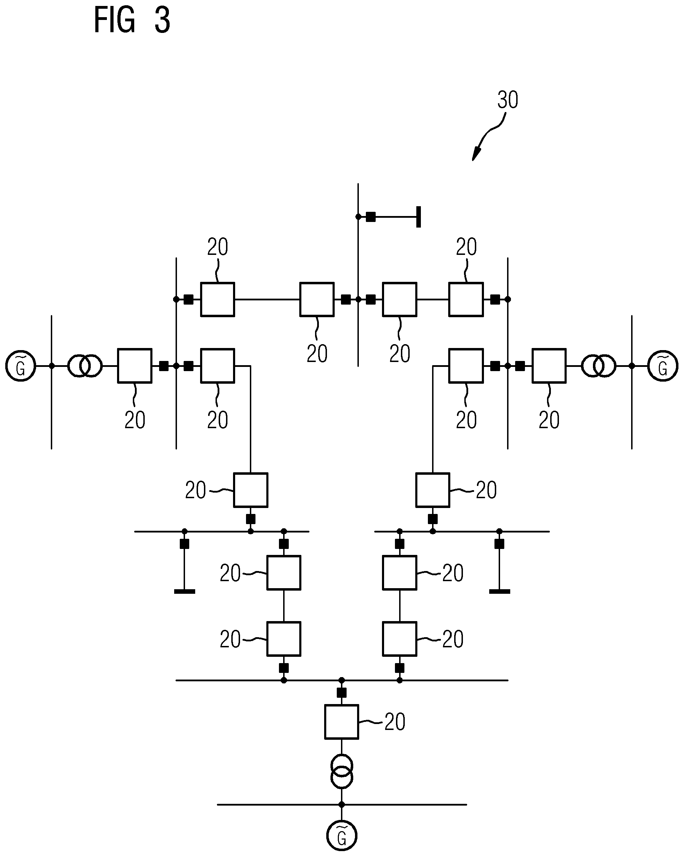

Da bei einem zentralen Schutzkonzept die koordinativen Entscheidungen fortfallen, kann das neuronale Netz in diesem Fall allein mit der ersten Trainingsstufe angelernt werden. Die Funktionsweise der Schutzeinrichtung 20 soll nachfolgend anhand der Figuren 3 bis 8 näher erläutert werden.

Figur 3 zeigt das Ersatzschaltbild eines Energieversorgungsnetzes 30 in Form eines IEEE 9 Bus Systems. Dieses dient als exemplarische Referenz für die nachfolgende Beschreibung eines Trainingsansatzes für neuronale Netze zum Zwecke ihres Einsatzes in der elektrischen Netzschutztechnik. In dem Referenznetz sind in örtlicher Nähe zu jeweiligen Messstellen Schutzeinrichtungen 20 vorgesehen, von denen jede anstelle einer deterministischen Schutzlogik über ein trainiertes neuronales Netz verfügt, welches lokal in der Schutzeinrichtung 20a-o gespeichert ist. Obwohl die Schutzeinrichtungen 20 dazu trainiert sind, eigenständig alle Schutzfunktionen auszuführen, ohne auf die Kommunikation mit anderen Schutzeinrichtungen angewiesen zu sein, können sie unter Verwendung der optionalen Kommunikationsschnittstelle 23 (vgl. Figur 2) über eine temporäre Kommunikationsmöglichkeit zu einer übergeordneten Instanz verfügen, die eine Anpassung der Kantengewichte der neuronalen Netze vornehmen kann. Dies dient lediglich dazu, dass bei Änderungen der Topologie des elektrischen Energieversorgungsnetzes eine Anpassung der jeweiligen neuronalen Netze an die aktuelle Situation ermöglicht wird. Die Klassifizierung des aktuellen Betriebszustands des Energieversorgungsnetzes und eine etwaige im Fehlerfall damit verbundene Auslöseentscheidung jeder Schutzeinrichtung 20 wird ohne die Verwendung einer Kommunikationsverbindung getroffen und obliegt allein dem lokal gespeicherten neuronalen Netz, welches zuvor in einem Trainingsprozess an die individuellen Gegebenheiten des jeweiligen Einbauortes der Schutzeinrichtungen 20 angepasst wurde.

Für die Umsetzung des nachfolgend beschriebenen Ansatzes ist das Vorhandensein eines detaillierten Simulationsmodells des entsprechenden zu überwachenden Energieversorgungsnetzes dienlich, in welchem die Schutzeinrichtungen 20 eingesetzt werden. Zudem kann ein sogenanntes "Protection Security Assessment System" (PSA-System) verwendet werden, welches die automatisierte Bewertung von schutztechnischen Auslöseentscheidungen ermöglicht.

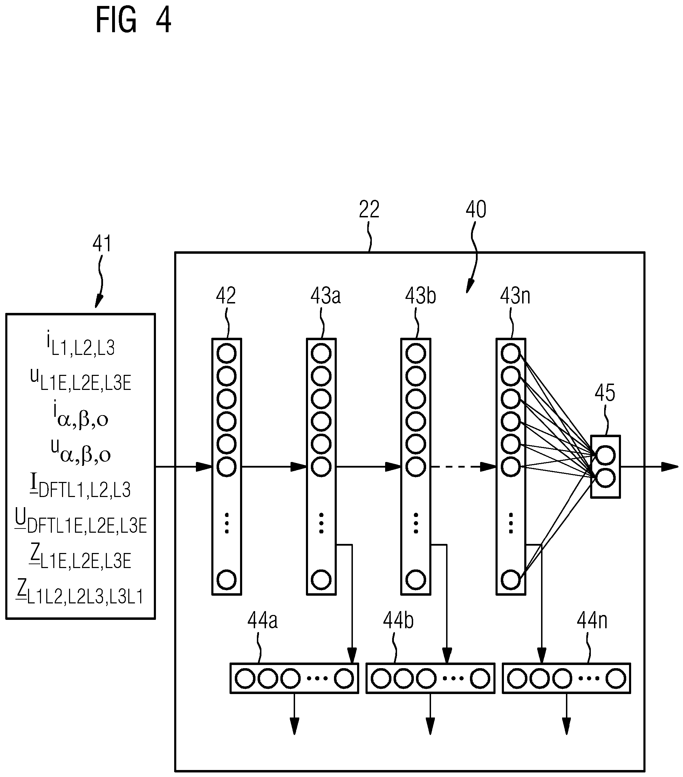

Figur 4 zeigt in vereinfachter Darstellung die in den Schutzeinrichtungen 20 eingesetzte Auswerteinrichtung 22 sowie die Struktur des eingesetzten neuronalen Netzes 40. Dem neuronalen Netz 40 werden eingangsseitig die von der Messwerterfassungseinrichtung 21 (vgl. Figur 2) bereitgestellten Messwerte in Form eines Eingangsvektors 41 zugeführt. Der Eingangsvektor 41 beinhaltet dabei Messwerte direkt gemessener und daraus abgeleiteter elektrischer Größen, anhand denen die Auslöseentscheidung durchgeführt werden kann. Solche elektrischen Größen können beispielsweise die folgenden sein, wobei die Aufzählung als nicht abschließend zu betrachten ist:
- Ströme der einzelnen Phasen i_{L1}, i_{L2}, i_{L3};
- Spannungen der einzelnen Phasen gegen Erde u_{L1E}, u_{L2E}, u_{L3E};
- α-, β- und 0-Komponenten einer Transformation (z.B. Clarke-Transformation) der Ströme und Spannungen;
- mittels einer Transformation in den Frequenzbereich (z.B. Discrete Fourier Transformation DFT) bestimmte Komponenten der Ströme und Spannungen;
- Impedanzen Z der einzelnen Leiter-Leiter sowie Leiter-Erde-Schleifen.

Dieser Eingangsvektor 41 wird den Neuronen der Eingangs-Neuronen-Schicht 42 des neuronalen Netzes 40 zugewiesen. Die weiterverzweigten Verbindungen des neuronalen Netzes 40 umfassen mehrere Zwischen-Neuronen-Schichten 43a-n und erstrecken sich bis zur Schicht 43n. Mit zumindest einer der Zwischen-Neuronen-Schichten 43a-n steht eine Zwischenausgabe-Neuronen-Schicht 44a-n zur Ausgabe von Zwischenergebnissen einzelnen Schutzfunktionen in Verbindung. Beispielsweise können eine erste Zwischenausgabe-Neuronen-Schicht 44a zur Ausgabe eines Zwischenergebnisses bzgl. einer Ereignisklassifizierung, eine zweite Zwischenausgabe-Neuronen-Schicht 44b zur Ausgabe eines Zwischenergebnisses bzgl. einer Fehlerart und eine weitere Zwischenausgabe-Neuronen-Schicht 44n zur Ausgabe eines Zwischenergebnisses bzgl. einer Fehlerortbestimmung vorgesehen sein. Somit können die Zwischenausgabe-Neuronen-Schichten 44a-n aggregierte Zwischenergebnisse liefern, die konkrete Aussagen bezüglich der Ereignisklassifizierung (z.B. Kurzschluss, Inrush, Last, Pendelung), der Fehlerart (z.B. 3-polig, 2-polig, 1-polig) und dem detektierten Fehlerort machen. Weitere Zwischenausgabe-Neuronen-Schichten für Zwischenergebnisse bzgl. zusätzlicher Schutzfunktionen können außerdem vorgesehen sein. Ein wesentlicher Vorteil der Integration dieser zusätzlichen Zwischenausgabe-Neuronen-Schichten 44a-n liegt in der Erhöhung der Entscheidungstransparenz des neuronalen Netzes.

Schließlich ist die letzte Zwischen-Neuronen-Schicht 43n mit einer Ausgabe-Neuronen-Schicht 45 verbunden, die eine vollständige Klassifizierung des aktuellen Betriebszustands des Energieversorgungsnetzes ausgibt.

Für eine dezentral eingesetzte Schutzeinrichtung 20 ist wie erwähnt ein zweistufiger Trainingsprozess vorgesehen. Innerhalb eines ersten Abschnittes umfassend die Eingangs-Neuronen-Schicht 42 und die Zwischen-Neuronen-Schichten 43a-n erfolgt eine Anpassung der Kantengewichte des neuronalen Netzes gemäß der ersten Trainingsstufe. Hierbei wird ein Vortraining auf Basis eines Deep Learning Ansatzes, bevorzugt mit Backpropagation, durchgeführt, bei welchem die Kantengewichte dieses ersten Abschnittes z.B. anhand eines simulierten Trainingsdatensatzes angepasst werden.

Im Zuge der ersten Trainingsstufe werden somit zunächst sämtliche Kombinationen aus Betriebsszenarien und Ereignissen mithilfe des Netzmodells simuliert und automatisiert gelabelt. Das Labeling, also die Vorklassifizierung der einzelnen Szenarien, weist hierbei auf die Ereignisart, die Kurzschlussart und den Kurzschlussort hin.

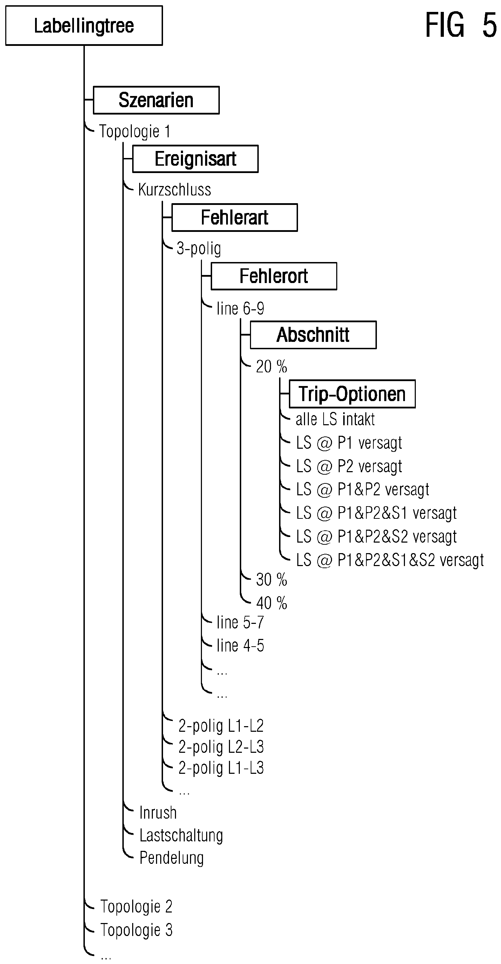

Ein exemplarischer Klassifizierungsbaum ("Labelingtree") ist in Figur 5 dargestellt und zeigt die Struktur eines Ausführungsbeispiels der eingesetzten Labels. Auf oberster Ebene sind hier die Szenarien zu finden, welche eine Kombination aus der Topologie und der aktuellen Betriebssituation des elektrischen Energieversorgungsnetzes widerspiegeln. Nachfolgend wird zwischen den Ereignisklassen unterschieden, die jeweils eine individuelle Unterstruktur besitzen. Hier ist nur die Struktur der Kurzschlussklasse dargestellt. Diese gliedert sich in die Fehlerart, den Fehlerort (Betriebsmittel), den Abschnitt und die jeweiligen Trip-Optionen. Diese Trip-Optionen stellen unterschiedliche Varianten hinsichtlich des potentiellen Auslöseverhaltens der Schutzeinrichtungen dar. LS steht hierbei für Leistungsschalter, während P und S auf die Einbauorte des Primär- und Sekundärschutzes hindeuten. Diese Versagensvarianten der einzelnen Leistungsschalter sind dienlich, um dem neuronalen Netz das Training des sekundären und tertiären Reserveschutzverhaltens zu ermöglichen.

Nach Abschluss des Vortrainings in der ersten Trainingsstufe werden daher die ermittelten Kantengewichte der betreffenden Verbindungen "eingefroren" und in der nachfolgenden zweiten Trainingsstufe nicht mehr verändert. Das Prinzip des Deep Learning Ansatzes mit Backpropagation kann nämlich beim dezentralen Einsatz der Schutzeinrichtungen nicht bis zur finalen Ausgabe-Neuronen-Schicht 45 weitergeführt werden, da das Verhalten einer Schutzeinrichtung im Zusammenspiel mit anderen Schutzeinrichtungen mittels Deep Learning nur mit einem unverhältnismäßig hohen Aufwand trainiert werden kann. Da nämlich für jede Schutzeinrichtung eine eigene Entscheidungsinstanz ohne Notwendigkeit der Kommunikation zu anderen Schutzeinrichtungen lokal im Gerät vorliegen soll, hängt für die einzelne Schutzeinrichtung die bestmögliche Musterlösung, aus der sich das Labeling für diesen Fall ableiten ließe, vom Verhalten der anderen Schutzgeräte ab. Theoretisch wäre es zwar möglich, all diese denkbaren Fälle an externen Auslösesequenzen in der Umgebung der zu trainierenden Schutzeinrichtung zu simulieren. Jedoch wäre das Aufstellen dieser Fälle und das entsprechende Labeling aufwändiger als die Konfiguration einer deterministischen Schutzlogik (beispielsweise eines Distanzschutzes) für einige Referenzszenarien zu berechnen, weshalb dieser Weg als unpraktikabel erscheint. Damit ist im dezentralen Einsatz eine zweite Trainingsstufe notwendig.

Die Kantengewichte der Verbindungen zwischen der Zwischen-Neuronen-Schicht 43n und der finalen Ausgabe-Neuronen-Schicht 45 werden in der zweiten Trainingsstufe durch Anwendung eines Reinforcement Learning Ansatzes festgelegt und optimiert.

Zunächst werden hierbei mehrere Exemplare eines jeden neuronalen Netzes, welches das Vortraining für einen entsprechenden Schutzeinrichtungseinbauort gemäß der ersten Trainingsstufe durchlaufen hat, generiert und eine initiale Belegung ihrer Kantengewichtung zwischen der letzten Zwischen-Neuronen-Schicht 43n und der finalen Ausgabe-Neuronen-Schicht 45 nach dem Zufallsprinzip festgelegt. Nachfolgend werden diese Exemplare z.B. einem evolutionären Selektionsprozess unterzogen. Hierfür wird erneut das bereits in der ersten Trainingsstufe verwendete Simulationsmodell des Netzabschnittes eingesetzt. Es wird diesmal jedoch kein im Vorfeld simulierter Trainingsdatensatz verwendet, vielmehr können die neuronalen Netze, welche jeweils eine Schutzeinrichtung repräsentieren, die Simulation nun direkt als Umwelt wahrnehmen und mit dieser wechselwirken, indem sie sie durch ihre Auslöseentscheidung beeinflussen.

Hierzu werden zunächst Simulation, welche einen Kurzschluss oder ein anderes Ereignis beinhalten, durchgeführt und aufgezeichnet. Die aufgezeichneten Größen des Inputvektors werden den durch die vortrainierten neuronalen Netze repräsentierten Schutzeinrichtungen unter Berücksichtigung ihres jeweiligen Einbauortes vorgespielt und deren Auslöseentscheidung wird in einer Ereignisliste protokolliert. Die aufgezeichneten Simulationsdaten sind folglich nur bis zum Zeitstempel des ersten Auslösebefehls korrekt, da dieser Eingriff üblicherweise eine Topologieänderung nach sich ziehen würde. Daher wird die Simulation unter Einbeziehung des ersten abgegebenen Auslösebefehls wiederholt und die Ergebnisse werden den die Schutzeinrichtungen repräsentierenden neuronalen Netzen erneut vorgespielt. Die Schutzeinrichtung, welche diesen ersten Auslösebefehl abgegeben hatte, darf in dieser Runde jedoch nicht erneut teilnehmen. Diese Schleife wird so lange wiederholt, bis die Simulation ohne das Hinzufügen neuer Auslösebefehle abgespielt wurde, oder bis alle Schutzeinrichtungen ausgelöst haben. Anschließend erfolgt eine Einzelbewertung einer jeden Schutzeinrichtung, z.B. durch ein PSA-System. Hierbei werden Boni für eine rasche Auslösung nach Fehlereintritt vergeben. Für Auslöseentscheidungen, die bestimmten Regeln zuwiderhandeln, erhält eine Schutzeinrichtung Mali. Die Einzelbewertungen werden daraufhin aufsummiert, um eine Gesamtpunktzahl zu bilden.

Der komplette Prozess daraufhin mit neuen neuronalen Netzen der Schutzeinrichtungen wiederholt, bis für alle Gruppen (gebildet aus dem Zusammenspiel von jeweils einem neuronalen Netzexemplar aller Einbauorte) ein Gesamtergebnis vorliegt. Die Gruppen werden daraufhin in absteigender Reihenfolge ihrer Gesamtpunktzahl sortiert, wobei die besten 10 % fortbestehen und die anderen 90 % ausselektiert werden. Nun folgt die Generierung neuer Exemplare, um die Population der neuronalen Netze wieder auf den ursprünglichen Wert aufzustocken. Die neu hinzukommenden Nachkommen entsprechen dabei den Exemplaren der Gruppe, aus der sie hervorgehen, weisen jedoch zufällige Abwandlungen ihrer Kantengewichte zwischen der letzten Zwischen-Neuronen-Schicht 43n und der finalen Ausgabe-Neuronen-Schicht 45 auf. Dabei erfahren diejenigen neuronalen Netze der Schutzeinrichtungen, welche innerhalb der jeweiligen Gruppe die niedrigste Einzelpunktzahl zur Gesamtpunktzahl der Gruppe beisteuerten, eine stärkere Abänderung ihrer Kantengewichte. Anschließend beginnt der Prozess von neuem und wird erst beendet, wenn keine nennenswerten Verbesserungen der Gesamtpunktzahl der besten Gruppe mehr auftreten.

Nach diesem zweiten Trainingsvorgang sind die neuronalen Netze, unter Berücksichtigung des jeweiligen Einbauortes, derart trainiert, dass sie im operativen Betrieb des Energieversorgungsnetzes eigenständige Entscheidungen zur Klassifizierung des Betriebszustandes treffen können.

Bei einem zentralen Schutzkonzept fällt die zweite Trainingsstufe fort. Unter der Annahme, dass statt einer dezentralen Entscheidungsstruktur eine singuläre zentrale Schutzeinrichtung auf Basis eines einzelnen neuronalen Netzes eingesetzt wird, die sämtliche gemessenen Eingangsgrößen aller Schutzeinrichtungseinbauorte erhält und mit ihrer Ausgabeschicht sämtliche Leistungsschalter im Netzgebiet ansteuert, ist es nämlich möglich, das Prinzip des Deep Learning mit Backpropagation bis hin zur finalen Ausgabe-Neuronen-Schicht fortzusetzen, da das automatisierte Labeling der Simulationsdaten aus einer einzelnen simplen Musterlösung abgeleitet werden kann. Für jede Variante der untersten Hierarchiestufe des Klassifizierungsbaums in der Unterstruktur der Kurzschlussereignisse (vgl. Figur 5) soll die zentrale Schutzeinrichtung bei Erkennung eines Kurzschlusses vom prognostizierten Kurzschlussort in alle topologischen Richtungen ausgehend der Reihe nach Auslösebefehle an die entsprechenden Leistungsschalter senden. Gelingt beispielsweise die Öffnung eines Leistungsschalters am Ort des Primärschutzes nicht, so werden die weiter vom Kurzschluss entfernten Leistungsschalter an den Orten des Sekundärschutzes angesprochen. Für das Beispiel in Figur 5 könnte bei Zugrundelegung einer zentralen Schutzeinrichtung gemäß dieses Prinzips jeweils eine Musterlösung für die Elemente der tiefsten Hierarchieebene (LS-Verhalten) als Trainingslabel definiert werden.

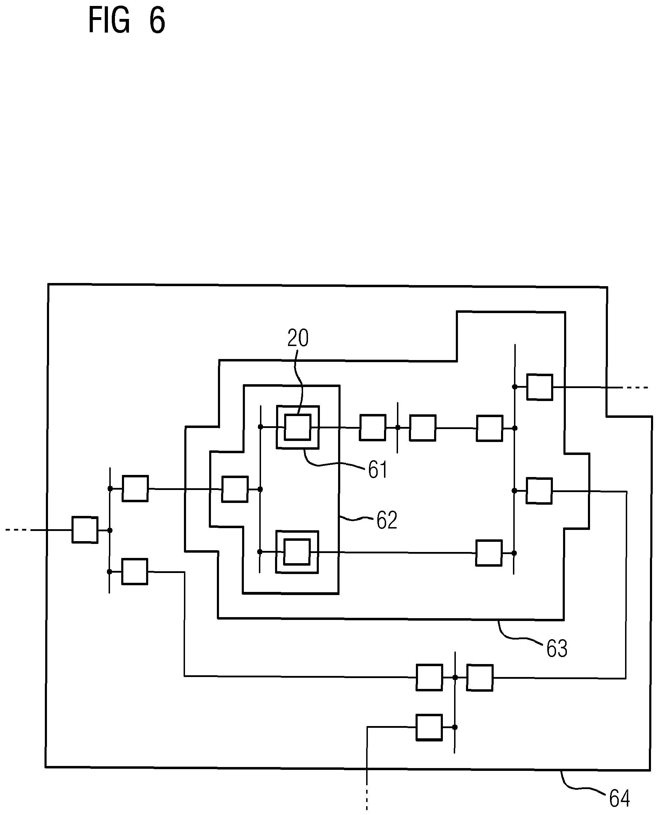

Wie bereits erwähnt, zeichnet sich die vorgeschlagene Lösung durch eine hohe Skalierbarkeit zwischen einem dezentralen und einem zentralen Schutzansatz aus. Eine Schutzarchitektur, bei welcher die aus der aktuell üblichen Praxis bekannten Schutzgeräteeinbauorte (typischerweise die einzelnen Sammelschienenabgänge der Netzstationen) als Einsatzebene autark agierender neuronaler Netze zugrunde gelegt wurden, wird als dezentraler Ansatz bezeichnet. Der beschriebene Lösungsansatz ist jedoch nicht auf diese Ausprägungsform beschränkt, sondern kann hinsichtlich der Einsatzebene skaliert werden. Dies soll anhand eines Beispiels in Figur 6 verdeutlicht werden. Hier ist ein beispielhaftes elektrisches Energieversorgungsnetz dargestellt. Da das Simulationsmodell des Energieversorgungsnetzes eine essentielle Rolle sowohl in der ersten Trainingsphase, als auch in der zweiten Trainingsphase einnimmt, definieren die Grenzen des Simulationsmodells hinsichtlich der Skalierung des beschriebenen Lösungsansatzes die theoretische Obergrenze der Einsatzebene. Mit dem Bezugszeichen 61 ist in Figur 6 die Einsatzebene des komplett dezentralen Ansatzes eingezeichnet. Steigert man die Einsatzebene auf Stationslevel (Bezugszeichen 62), so betrifft dies im dargestellten Beispiel drei Abgänge. Im Gegensatz zum komplett dezentralen Ansatz wird nun statt drei autarker trainierter neuronaler Netze nur ein entsprechend anders trainiertes neuronales Netz eingesetzt. Diesem stehen nun die Messwerte aller drei Abgänge im Eingangsvektor zur Verfügung und die finale Ausgabe-Neuronen-Schicht besitzt nun vier Ausgangsneuronen (keine Auslösung, Auslösung Leistungsschalter Abgang1, ... Abgang2, ... Abgang3). Diese Skalierungsbetrachtung lässt sich auch über die Stationsebene hinweg ausdehnen, wodurch ganze Netzregionen (Bezugszeichen 63) gemäß diesem Prinzip zu einem autark agierenden neuronalen Netz zusammengefasst werden. Wie bereits erwähnt, liegt die theoretische Obergrenze dieser Ausdehnung bei den Grenzen des Simulationsmodells. Diese Ausprägungsform des Lösungsansatzes wird als zentraler Ansatz bezeichnet (Bezugszeichen 64).

Bei detaillierter Betrachtung lässt sich die Erkenntnis ableiten, dass die schrittweise Erhöhung der Einsatzebene vom dezentralen Ansatz in Richtung des zentralen Ansatzes den Trainingsaufwand in der zweiten Trainingsphase (Reinforcement Learning) immer weiter verringert, bis bei Erreichen des zentralen Ansatzes das Reinforcement Learning entfallen kann, da hier eine singuläre Entscheidungsinstanz vorliegt, welche das Trainingsdatenlabeling auch hinsichtlich der finalen Ausgabe-Neuronen-Schicht auf einfachem Wege automatisierbar macht. Gleichzeitig steigen mit der Erhöhung der Einsatzebene jedoch die Kommunikationsabhängigkeit des Verfahrens und die Entfernungen, über die der Informationsaustausch hinweg stattfinden muss. Hinsichtlich dessen weist der dezentrale Ansatz zwar den höchsten Trainingsaufwand in der zweiten Trainingsstufe auf, stellt jedoch eine verlässliche Fallback-Lösung dar, da seine Auslöseentscheidung keine Kommunikationsverbindung erfordert.

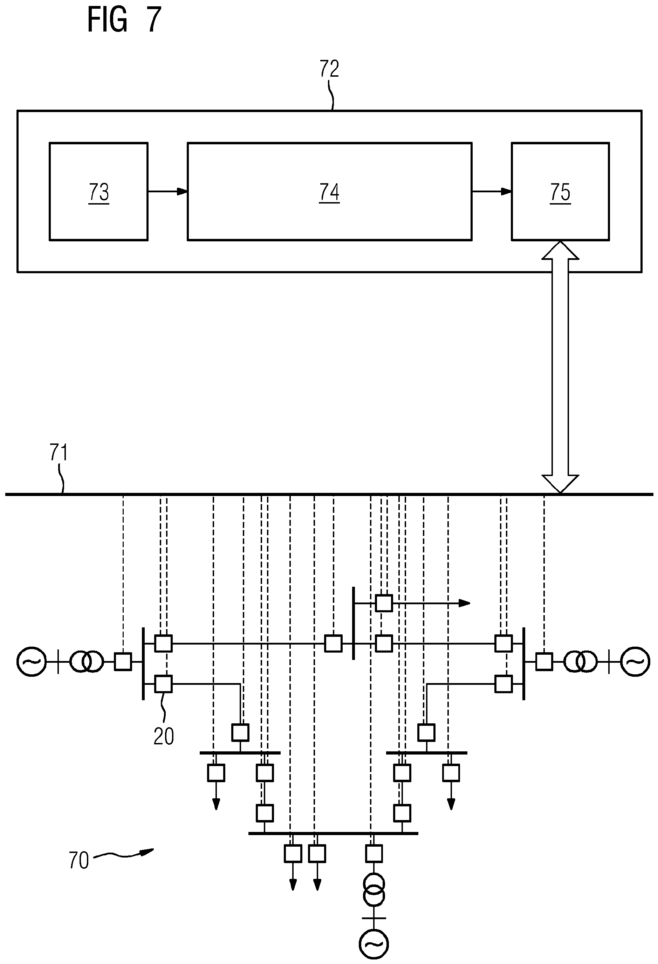

In Figur 7 ist schematisch eine dezentrale Schutzarchitektur dargestellt. Ein beispielhaft gezeigtes Energieversorgungsnetz 70 umfasst eine Vielzahl von Schutzeinrichtungen 20, die als kleine Rechtecke in Figur 7 angedeutet sind. Die Schutzeinrichtungen sind in örtlicher Nähe zu Messstellen des Energieversorgungsnetzes angeordnet und in nicht dargestellter Weise mit Messsensoren zur Aufnahme von Messwerten verbunden. Außerdem stehen sie in einer Wirkverbindung mit Schalteinrichtungen im Energieversorgungsnetz, um diese im Fehlerfall zum Unterbrechen des Stromflusses zu veranlassen.

Jede der Schutzeinrichtungen 20 ist wie im Zusammenhang mit den Figuren 2 und 4 beschrieben ausgebildet und umfasst insbesondere eine Auswerteinrichtung, die in Form eines speziell trainierten neuronalen Netzes ausgebildet ist. Bei der hier vorliegenden dezentralen Schutzarchitektur wurde hierzu wie oben beschrieben ein zweistufiger Trainingsansatz verwendet. Dadurch ist jede Schutzeinrichtung 20 in der Lage, selbständig alle notwendigen Schutzfunktionen durchzuführen und eine Entscheidung darüber zu treffen, ob sich das Energieversorgungsnetz 70 in einem zulässigen oder einem unzulässigen Betriebszustand befindet. Im Falle eines unzulässigen Betriebszustands kann mit dem neuronalen Netz eine vollständige Fehlerklassifizierung stattfinden. Außerdem kann das neuronale Netz auf Entscheidungen anderer Schutzeinrichtungen 20 reagieren, ohne hierzu in einer Kommunikationsverbindung mit diesen zu stehen.

Die Schutzeinrichtungen 20 weisen lediglich eine Kommunikationsverbindung zu einem Stationsbus 71 auf, um temporär mit einer übergeordneten Leitstelle 72 Daten austauschen zu können. Im übrigen Betrieb arbeitet jede der Schutzeinrichtungen vollständig selbständig.

Die übergeordnete Leitstelle 72 kann beispielsweise als dedizierte Netzleitstelle mit einer oder mehreren Datenverarbeitungseinrichtung zur Überwachung und Steuerung des Energieversorgungsnetzes 70 ausgebildet sein. Alternativ kann die Leitstelle 72 auch in einem Cloud-Computing-System, wie z.B. der Siemens Mindsphere^{®}, ausgebildet sein und ihre Funktionen als Cloudservice zur Verfügung stellen.

Die Leitstelle 72 dient neben ihren Überwachungs- und Steuerfunktionen auch zum Training der neuronalen Netze der Schutzeinrichtungen 20. Hierzu weist die Leitstelle 72 eine Simulationseinheit 73 auf, die eine Simulation des Verhaltens des Energieversorgungsnetzes 72 in allen möglichen Betriebsszenarien durchführt und ein automatisches Labeling der Ergebnisse vornimmt. Beispielsweise kann die Simulationseinheit 73 hierzu einen sogenannten "digitalen Zwilling" des Energieversorgungsnetzes 70 umfassen. Die Simulationseinheit 73 gibt ausgangsseitig gelabelte Trainingsdaten für den Trainingsprozess der neuronalen Netze der Schutzeinrichtungen 20 ab.

Die Trainingsdaten werden einer Trainingseinheit 74 zugeführt, in der der oben detailliert beschriebene zweistufige Trainingsprozess durchgeführt wird. Ausgangsseitig gibt die Trainingseinheit 74 Parameter in Form von Kantengewichten für die neuronalen Netze der Schutzeinrichtungen 20 ab, wobei bei der Erzeugung der Kantengewichte der Einbauort der jeweiligen Schutzeinrichtung 20 berücksichtigt wird.

Die Kantengewichte werden an eine Kommunikationseinheit 75 weitergegeben, die mit dem Stationsbus 71 und damit mit den Schutzeinrichtungen 20 in Verbindung steht. Die Kommunikationseinrichtung 75 überträgt die Kantengewichte an die Schutzeinrichtungen 20, die diese zum Konfigurieren ihrer neuronalen Netze nutzen.

Die Kantengewichte können im Laufe des Betriebs des Energieversorgungsnetzes bei Bedarf angepasst werden, um die Schutzeinrichtungen an neue Gegebenheiten wie z.B. geänderte Netztopologien anzupassen.

Des Weiteren übermitteln die Schutzeinrichtungen 20 an die Leitstelle 72 Betriebsdaten des Energieversorgungsnetzes 70, die beispielsweise Netz- und Schaltzustände sowie im Fehlerfall aufgenommene Störschriebe umfassen.

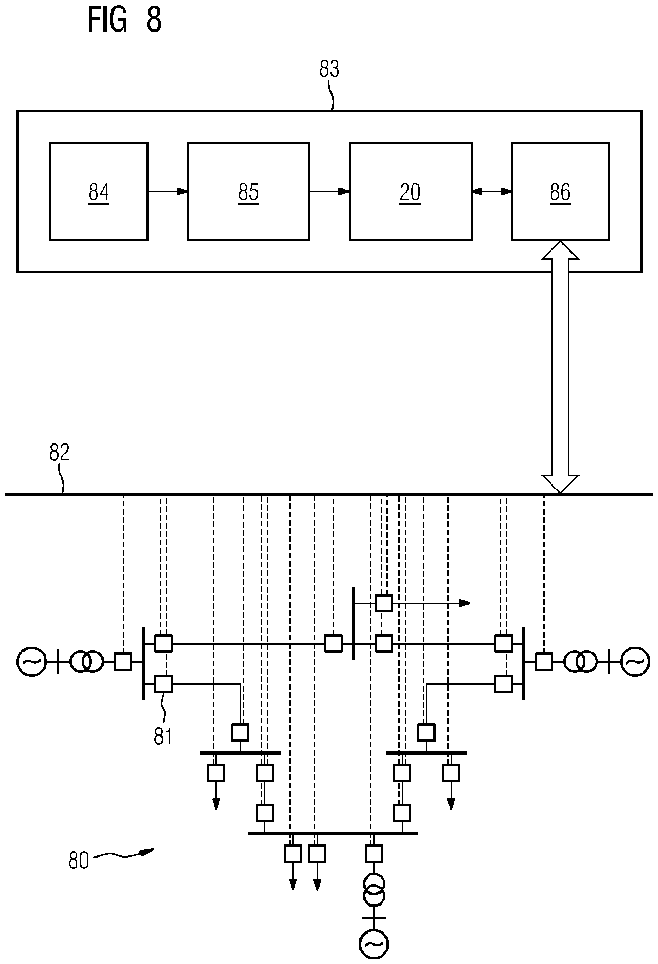

Figur 8 zeigt schließlich ein Ausführungsbeispiel einer zentralen Schutzarchitektur. Das in Figur 8 gezeigte Energieversorgungsnetz 80 weist im Gegensatz zum Energieversorgungsnetz 70 der Figur 7 keine Schutzeinrichtungen 20 mehr auf. Stattdessen sind Messeinrichtungen 81, z.B. sogenannte Merging Units, mit denen Messwerte verschiedener Wandler zusammengefasst werden, vorgesehen, die an den Messstellen aufgenommene Messwerte an einen Prozessbus 82 übermitteln. Außerdem weist das Energieversorgungsnetz 80 Aktoreinrichtungen zum Ansteuern von Schalteinrichtungen auf. Diese können in den Messeinrichtungen 81 integriert oder als separate Geräte ausgebildet sein. Somit umfasst das Energieversorgungsnetz 80 keinerlei dezentrale Intelligenz zur Erkennung von unzulässigen Betriebszuständen.

Der Prozessbus 82 steht mit einer Leitstelle 83 in Verbindung, die wie die Leitstelle 72 der Figur 7 als dedizierte Leitstelle oder in einem Cloud-Computing-System ausgebildet sein kann und eine Simulationseinheit 84 aufweist, mit der ebenfalls alle möglichen Betriebsszenarien des Energieversorgungsnetzes 80 simuliert und gelabelte Trainingsdaten erzeugt werden.

Die gelabelten Trainingsdaten werden einer Trainingseinheit 85 zugeführt, die den oben beschriebenen einstufigen Trainingsprozess durchführt und Kantengewichte ausgibt. Die Kantengewichte werden einer in der Leitstelle 83 ausgebildeten zentralen Schutzeinrichtung 20 zugeführt, wo sie zur Konfiguration des neuronalen Netzes verwendet werden. Im Unterschied zur Situation in Figur 7 ist das neuronale Netz der Schutzeinrichtung 20 der Figur 8 dazu trainiert, für das vollständige Energieversorgungsnetz 80 eine Entscheidung über den Betriebszustand zu treffen und ggf. eine Fehlerklassifizierung durchzuführen. Dazu verwendet die Schutzeinrichtung 20 der Figur 8 die an allen Messstellen aufgenommenen Messwerte, die ihr beispielsweise als fortlaufender Stream über den Prozessbus und eine Kommunikationseinheit 86 zur Verfügung gestellt werden. Erkennt die Schutzeinrichtung 20 einen Fehler, sendet sie über die Kommunikationseinheit 86 ein Auslösesignal an die betreffende Aktoreinrichtung im Energieversorgungsnetz 80, um den Fehlerstrom durch Öffnen einer oder mehrerer Schalteinrichtungen zu unterbrechen.
Voranstehend wurde somit eine neue Schutzeinrichtung 20 beschrieben, die ein neuronales Netz umfasst, mit dem sie sämtliche Schutzfunktionen gemeinsam bearbeitet. Die Schutzeinrichtung 20 kann in dezentralen sowie zentralen Schutzarchitekturen eingesetzt werden, wobei ihr Trainingsprozess an die jeweilige Architektur angepasst wird. Die beschriebene Schutzeinrichtung 20 weist zusammengefasst unter anderem folgende Vorteile auf:
- Die Schutzeinrichtung stellt ein selbstlernendes System dar sich permanent dem sich ändernden Netz anpasst.
- Die Schutzeinrichtung zeichnet sich durch eine hohe Selektivität und schnelle Auslösezeiten aus.
- Die Schutzeinrichtung ist unabhängig von einer Gerätehardware.
- Die Schutzeinrichtung kann für jede beliebige Topologie des Energieversorgungsnetzes auf beliebiger Ebene (Feldebene, Stationsebene, Leitstellenebene) eingesetzt werden.

Obwohl die Erfindung vorstehend im Detail durch bevorzugte Ausführungsbeispiele näher illustriert und beschrieben worden ist, ist die Erfindung nicht durch die offenbarten Beispiele eingeschränkt und andere Variationen können vom Fachmann hieraus abgeleitet werden, ohne den Schutzumfang der nachfolgenden Patentansprüche zu verlassen.

## Patentansprüche

1. Schutzeinrichtung (20) zum Überwachen eines elektrischen Energieversorgungsnetzes (30, 70, 80), mit
- einer Messwerterfassungseinrichtung (21) zum Erfassen von Messwerten, die an zumindest einer Messstelle des Energieversorgungsnetzes (30, 70, 80) aufgenommen worden sind und einen elektrischen Zustand des Energieversorgungsnetzes (30, 70, 80) an der Messstelle angeben; und
- einer Auswerteinrichtung (22), die mit der Messwerterfassungseinrichtung (21) in Verbindung steht und dazu eingerichtet ist, auf Basis der Messwerte mehrere Schutzfunktionen auszuführen und als Ergebnis der Ausführung der Schutzfunktionen eine Entscheidung zu treffen, ob sich das Energieversorgungsnetz (30, 70, 80) in einem zulässigen oder einem unzulässigen Betriebszustand befindet, wobei
- die Auswerteinrichtung (22) vollständig in Form eines einzigen neuronalen Netzes (40) ausgebildet ist und eine Eingangs-Neuronen-Schicht (42), der die Messwerte und/oder davon abgeleitete Werte zugeführt werden, zumindest eine Zwischen-Neuronen-Schicht (43a-n) und eine Ausgangs-Neuronen-Schicht (45) aufweist, die eine Klassifizierung von Betriebszuständen des Energieversorgungsnetzes ausgibt, wobei das neuronale Netz (40) zur Klassifizierung der Betriebszustände dazu trainiert ist, alle Schutzfunktionen gemeinsam auszuführen, **dadurch gekennzeichnet, dass**
- zumindest eine der Zwischen-Neuronen-Schichten (43a-n) mit einer Zwischenausgabe-Neuronen-Schicht (44a-n) verbunden ist, wobei jede Zwischenausgabe-Neuronen-Schicht (44a-n) ein für eine einzelne Schutzfunktion spezifisches Ergebnis ausgibt.

2. Schutzeinrichtung (20) nach Anspruch 1,
**dadurch gekennzeichnet, dass**
- die Schutzfunktionen mindestens eine Klassifizierung eines Ereignisses, eine Erkennung einer Fehlerart und eine Bestimmung eines Fehlerortes umfassen.

3. Schutzeinrichtung (20) nach einem der vorangehenden Ansprüche,
**dadurch gekennzeichnet, dass**
- die Schutzeinrichtung (20) zum lokalen Betrieb an einem Einbauort in der Nähe der Messstelle eingerichtet ist und eine Kommandoeinrichtung zur Ausgabe von Steuerbefehlen an Schalteinrichtungen des Energieversorgungsnetzes (30, 80) aufweist; und
- das neuronale Netz (40) in einem zweistufigen Lernverfahren auf die Klassifizierung von Betriebszuständen des Energieversorgungsnetz (30, 80) trainiert ist.

4. Schutzeinrichtung (20) nach Anspruch 3,
**dadurch gekennzeichnet, dass**
- die Schutzeinrichtung (20) spezifisch auf den Einsatz an ihrem Einbauort trainiert ist.

5. Schutzeinrichtung (20) nach Anspruch 3 oder 4,
**dadurch gekennzeichnet, dass**
- die Schutzeinrichtung (20) eine Kommunikationsschnittstelle (23) zur Verbindung mit einer übergeordneten Leitstelle (72) aufweist und zum Empfang von Parametern zur Kalibrierung des neuronalen Netzes (40) aufweist.

6. Schutzeinrichtung (20) nach einem der Ansprüche 3 bis 5,
**dadurch gekennzeichnet, dass**
- das neuronale Netz (40) in der ersten Stufe über ein Deep Learning Verfahren trainiert ist und in der zweiten Stufe über ein Reinforcement Learning Verfahren trainiert ist.

7. Schutzeinrichtung (20) nach Anspruch 1 oder 2,
**dadurch gekennzeichnet, dass**
- die Schutzeinrichtung (20) eine zentrale Schutzeinrichtung ist, die dazu eingerichtet ist, von Sensoren an mehreren Messstellen des Energieversorgungsnetzes (80) Messwerte zu empfangen und Schalteinrichtungen an mehreren Stellen des Energieversorgungsnetzes (80) anzusteuern; und
- das neuronale Netz (40) über ein einstufiges Lernverfahren auf die Klassifizierung von Betriebszuständen des Energieversorgungsnetz (80) trainiert ist.

8. Schutzeinrichtung (20) nach Anspruch 7,
**dadurch gekennzeichnet, dass**
- das neuronale Netz (40) über ein Deep Learning Verfahren trainiert ist.

9. Verfahren zum Überwachen eines elektrischen Energieversorgungsnetzes (30, 70, 80), bei dem
- an zumindest einer Messstelle des Energieversorgungsnetzes (30, 70, 80) Messwerte erfasst werden, die einen elektrischen Zustand des Energieversorgungsnetzes (30, 70, 80) an der Messstelle angeben;
- die Messwerte an eine Schutzeinrichtung (20) übermittelt werden; und
- auf Basis der Messwerte mittels einer Auswerteinrichtung (22) der Schutzeinrichtung (20), mehrere Schutzfunktionen ausgeführt werden und als Ergebnis der Ausführung der Schutzfunktionen eine Entscheidung getroffen wird, ob sich das Energieversorgungsnetz (30, 70, 80) in einem zulässigen oder einem unzulässigen Betriebszustand befindet, wobei
- die Schutzfunktionen mit einer Auswerteinrichtung (22) ausgeführt werden, die vollständig in Form eines einzigen neuronalen Netzes (40) ausgebildet ist und eine Eingangs-Neuronen-Schicht (42), der die Messwerte und/oder davon abgeleitete Werte zugeführt werden, zumindest eine Zwischen-Neuronen-Schicht (43a-n) und eine Ausgangs-Neuronen-Schicht (45) aufweist, die eine Klassifizierung von Betriebszuständen des Energieversorgungsnetzes (30, 70, 80) ausgibt, aufweist, **dadurch gekennzeichnet, dass**
- zumindest eine der Zwischen-Neuronen-Schichten (43a-n) mit einer Zwischenausgabe-Neuronen-Schicht (44a-n) verbunden ist, die ein für eine einzelne Schutzfunktion spezifisches Ergebnis ausgibt.

10. Verfahren nach Anspruch 9,
**dadurch gekennzeichnet, dass**
- vor einer Aufnahme der Überwachung des Energieversorgungsnetzes (30, 70, 80) das neuronale Netz (40) zur Klassifizierung der Betriebszustände dazu trainiert wird, alle Schutzfunktionen gemeinsam auszuführen.

11. Verfahren nach einem der Ansprüche 9 oder 10,
**dadurch gekennzeichnet, dass**
- bei einer Schutzeinrichtung (20), die zum lokalen Betrieb an einem Einbauort in der Nähe der Messstelle eingerichtet ist, das neuronale Netz (40) vor der Aufnahme der Überwachung in einem zweistufigen Lernverfahren auf die Klassifizierung von Betriebszuständen des Energieversorgungsnetzes (30, 70) trainiert wird.

12. Verfahren nach Anspruch 11,
**dadurch gekennzeichnet, dass**
- mit der ersten Stufe des Lernverfahrens die Struktur des neuronalen Netzes (40) von der Eingangs-Neuronen-Schicht (42) bis zu einer der Ausgangs-Neuronen-Schicht (45) unmittelbar vorgelagerten Zwischen-Neuronen-Schicht (43n) über ein Deep Learning Verfahren trainiert wird; und
- mit der zweiten Stufe des Lernverfahrens die Struktur des neuronalen Netzes (40) von der der Ausgangs-Neuronen-Schicht (45) unmittelbar vorgelagerten Zwischen-Neuronen-Schicht (43n) bis zur Ausgangs-Neuronen-Schicht (45) über ein Reinforcement Learning Verfahren trainiert wird.

13. Verfahren nach einem der Ansprüche 9 oder 10,
**dadurch gekennzeichnet, dass**
- bei einer Schutzeinrichtung (20), die dazu eingerichtet ist, als zentrale Schutzeinrichtung von Sensoren an mehreren Messstellen des Energieversorgungsnetzes (80) Messwerte zu empfangen und Schalteinrichtungen an mehreren Stellen des Energieversorgungsnetzes (80) anzusteuern, das neuronale Netz (40) vor der Aufnahme der Überwachung über ein einstufiges Lernverfahren auf die Klassifizierung von Betriebszuständen des Energieversorgungsnetzes (80) trainiert wird.

## Claims

1. Protective device (20) for monitoring an electrical energy supply network (30, 70, 80), having
- a measured value recording device (21) for recording measured values which have been recorded at at least one measurement point in the energy supply network (30, 70, 80) and indicate an electrical state of the energy supply network (30, 70, 80) at the measurement point; and
- an evaluation device (22) which is connected to the measured value recording device (21) and is configured to perform a plurality of protective functions on the basis of the measured values and, as the result of performing the protective functions, to make a decision as to whether the energy supply network (30, 70, 80) is in a permissible or impermissible operating state, wherein
- the evaluation device (22) is completely in the form of a single neural network (40) and has an input neuron layer (42), to which the measured values and/or values derived therefrom are supplied, at least one intermediate neuron layer (43a-n) and an output neuron layer (45) which outputs a classification of operating states of the energy supply network, wherein, in order to classify the operating states, the neural network (40) is trained to perform all protective functions together, **characterized in that**
- at least one of the intermediate neuron layers (43a-n) is connected to an intermediate output neuron layer (44a-n), wherein each intermediate output neuron layer (44a-n) outputs a result specific to an individual protective function.

2. Protective device (20) according to Claim 1,
**characterized in that**
- the protective functions comprise at least a classification of an event, detection of a type of fault and determination of a fault location.

3. Protective device (20) according to one of the preceding claims,
**characterized in that**
- the protective device (20) is configured for local operation at an installation location in the vicinity of the measurement point and has a command device for outputting control commands to switching devices of the energy supply network (30, 80); and
- the neural network (40) is trained to classify operating states of the energy supply network (30, 80) in a two-stage learning method.

4. Protective device (20) according to Claim 3,
**characterized in that**
- the protective device (20) is trained specifically for use at its installation location.

5. Protective device (20) according to Claim 3 or 4,
**characterized in that**
- the protective device (20) has a communication interface (23) for connection to a superordinate control centre (72) and for receiving parameters for calibrating the neural network (40) .

6. Protective device (20) according to one of Claims 3 to 5, **characterized in that**
- the neural network (40) is trained in the first stage using a deep learning method and is trained in the second stage using a reinforcement learning method.

7. Protective device (20) according to Claim 1 or 2,
**characterized in that**
- the protective device (20) is a central protective device which is configured to receive measured values from sensors at a plurality of measurement points in the energy supply network (80) and to control switching devices at a plurality of points in the energy supply network (80); and
- the neural network (40) is trained to classify operating states of the energy supply network (80) using a single-stage learning method.

8. Protective device (20) according to Claim 7,
**characterized in that**
- the neural network (40) is trained using a deep learning method.

9. Method for monitoring an electrical energy supply network (30, 70, 80), in which
- measured values are recorded at at least one measurement point in the energy supply network (30, 70, 80), which measured values indicate an electrical state of the energy supply network (30, 70, 80) at the measurement point;
- the measured values are transmitted to a protective device (20); and
- a plurality of protective functions are performed on the basis of the measured values by means of an evaluation device (22) of the protective device (20) and, as the result of performing the protective functions, a decision is made as to whether the energy supply network (30, 70, 80) is in a permissible or impermissible operating state, wherein
- the protective functions are performed using an evaluation device (22) which is completely in the form of a single neural network (40) and has an input neuron layer (42), to which the measured values and/or values derived therefrom are supplied, at least one intermediate neuron layer (43a-n) and an output neuron layer (45) which outputs a classification of operating states of the energy supply network (30, 70, 80), **characterized in that**
- at least one of the intermediate neuron layers (43a-n) is connected to an intermediate output neuron layer (44a-n) which outputs a result specific to an individual protective function.

10. Method according to Claim 9,
**characterized in that**
- before starting to monitor the energy supply network (30, 70, 80), in order to classify the operating states, the neural network (40) is trained to perform all protective functions together.

11. Method according to either of Claims 9 and 10,
**characterized in that**
- in the case of a protective device (20) which is configured for local operation at an installation location in the vicinity of the measurement point, the neural network (40) is trained to classify operating states of the energy supply network (30, 70) in a two-stage learning method before monitoring is started.

12. Method according to Claim 11,
**characterized in that**
- the structure of the neural network (40) from the input neuron layer (42) to an intermediate neuron layer (43n) directly upstream of the output neuron layer (45) is trained with the first stage of the learning method using a deep learning method; and
- the structure of the neural network (40) from the intermediate neuron layer (43n) directly upstream of the output neuron layer (45) to the output neuron layer (45) is trained with the second stage of the learning method using a reinforcement learning method.

13. Method according to either of Claims 9 and 10,
**characterized in that**
- in the case of a protective device (20) which is configured, as a central protective device, to receive measured values from sensors at a plurality of measurement points in the energy supply network (80) and to control switching devices at a plurality of points in the energy supply network (80), the neural network (40) is trained to classify operating states of the energy supply network (80) using a single-stage learning method before monitoring is started.

## Revendications

1. Dispositif (20) de protection pour le contrôle d'un réseau (30, 70, 80) d'alimentation en énergie électrique, comprenant
- un dispositif (21) de détection de valeurs de mesure pour la détection de valeurs de mesure, qui ont été prises à au moins un point de mesure du réseau (30, 70, 80) d'alimentation en énergie et qui indiquent un état électrique du réseau (30, 70, 80) d'alimentation en énergie au point de mesure ; et
- un dispositif (22) d'analyse, qui est en liaison avec le dispositif (21) de détection de valeurs de mesure et qui est agencé pour réaliser plusieurs fonctions de protection sur la base des valeurs de mesure et prendre, comme résultat de la réalisation des fonctions de protection, une décision sur le point de savoir, si le réseau (30, 70, 80) d'alimentation en énergie se trouve dans un état de fonctionnement admissible ou inadmissible, dans lequel
- le dispositif (22) d'analyse est constitué entièrement sous la forme d'un seul réseau (40) neuronal et a une couche (42) de neurones d'entrée, à laquelle les valeurs de mesure et/ou des valeurs qui s'en déduisent sont envoyées, au moins une couche (43a-n) de neurones intermédiaire et une couche (45) de neurones de sortie, qui donne un classement des états de fonctionnement du réseau d'alimentation en énergie, dans lequel le réseau (40) neuronal subit, pour le classement des états de fonctionnement, un apprentissage consistant à effectuer conjointement toutes les fonctions de protection,
**caractérisé en ce qu'**
- au moins l'une des couches (43a-n) de neurones intermédiaires est reliée à une couche (44a-n) de neurones de sortie intermédiaire, dans lequel chaque couche (44a-n) de neurones de sortie intermédiaire donne un résultat spécifique pour une fonction de protection individuelle.

2. Dispositif (20) de protection suivant la revendication 1, **caractérisé en ce que**
- les fonctions de protection comprennent au moins un classement d'un événement, d'une détection d'un type de défaut et une détermination d'un emplacement de défaut.

3. Dispositif (20) de protection suivant l'une des revendications précédentes,
**caractérisé en ce que**
- le dispositif (20) de protection est agencé pour le fonctionnement local en un emplacement d'implantation à proximité du point de mesure et a un dispositif d'instruction pour l'envoi d'instructions de commande à des dispositifs de coupure du réseau (30, 80) d'alimentation en énergie ; et
- le réseau (40) neuronal subit, dans un procédé d'apprentissage en deux stades, un apprentissage pour le classement d'états de fonctionnement du réseau (30, 80) d'alimentation en énergie.

4. Dispositif (20) de protection suivant la revendication 3, **caractérisé en ce que**
- le dispositif (20) de protections subit un apprentissage spécifique à l'utilisation à son emplacement d'implantation.

5. Dispositif (20) de protection suivant la revendication 3 ou 4,
**caractérisé en ce que**
- le dispositif (20) de protection a une interface (23) de communication pour la liaison avec un poste (72) de conduite supérieure hiérarchiquement et pour la réception de paramètres pour l'étalonnage du réseau (40) neuronal.

6. Dispositif (20) de protection suivant l'une des revendications 3 à 5,
**caractérisé en ce que**
- le réseau (40) neuronal subit, dans le premier stade, un apprentissage par un procédé deep learning et subit, dans le deuxième stade, un apprentissage par un procédé reinforcement learning.

7. Dispositif (20) de protection suivant la revendication 1 ou 2,
**caractérisé en ce que**
- le dispositif (20) de protection est un dispositif de protection central, qui est agencé pour recevoir de capteurs en plusieurs points de mesure du réseau (80) d'alimentation en énergie des valeurs de mesure, et pour commander les dispositifs de coupure en plusieurs points du réseau (80) d'alimentation en énergie ; et
- le réseau (40) neuronal subit, par un procédé d'apprentissage à un seul stade, un apprentissage pour le classement d'états de fonctionnement du réseau (80) d'alimentation en énergie.

8. Dispositif (20) de protection suivant la revendication 7, **caractérisé en ce que**
- le réseau (40) neuronal subit un apprentissage par un procédé deep learning.

9. Procédé de contrôle d'un réseau (30, 70, 80) d'alimentation en énergie électrique, dans lequel
- on détecte, en au moins un point de mesure du réseau (30, 70, 80) d'alimentation en énergie, des valeurs de mesure, qui indiquent un état électrique du réseau (30, 70, 80) d'alimentation en énergie au point de mesure ;
- on transmet les valeurs de mesure à un dispositif (20) de protection ; et
- sur la base des valeurs de mesure, on exécute, au moyen d'un dispositif (22) d'analyse du dispositif (20) de protection, plusieurs fonctions de protection et en résultat de l'exécution des fonctions de protection, on prend une décision sur le point de savoir, si le réseau (30, 70, 80) d'alimentation en énergie se trouve dans un état de fonctionnement admissible ou inadmissible, dans lequel
- on exécute les fonctions de protection par un dispositif (22) d'analyse, qui est constitué uniquement sous la forme d'un seul réseau (40) neuronal et qui a une couche (42) de neurones d'entrée, à laquelle sont envoyées les valeurs de mesure et/ou des valeurs qui s'en déduisent, au moins une couche (43a-n) de neurones intermédiaire et une couche(45) de neurones de sortie, qui donne un classement d'états de fonctionnement du réseau (30, 70, 80) d'alimentation en énergie,
**caractérisé en ce qu'**
- au moins l'une des couches (43a-n) de neurones intermédiaire est reliée à une couche (44a-n) de neurones de sortie intermédiaire, dans lequel chaque couche (44a-n) de neurones de sortie intermédiaire donne un résultat spécifique pour une fonction de protection individuelle.

10. Procédé suivant la revendication 9,
**caractérisé en ce que**
- avant un enregistrement du contrôle du réseau (30, 70, 80) d'alimentation en énergie, on fait subir au réseau (40) neuronal pour le classement des états de fonctionnement un apprentissage en exécutant conjointement toutes les fonctions de protection.

11. Procédé suivant la revendication 9 ou 10,
**caractérisé en ce que**
- pour un dispositif (20) de protection, qui est agencé pour le fonctionnement local en un emplacement d'implantation à proximité du point de mesure, on fait subir au réseau (40) neuronal, avant l'enregistrement du contrôle dans un procédé d'apprentissage en deux stades, un apprentissage pour le classement d'états de fonctionnement du réseau (30, 70) d'alimentation en énergie.

12. Procédé suivant la revendication 11,
**caractérisé en ce que**
- par le premier stade du procédé d'apprentissage, on fait subir à la structure du réseau (40) neuronal, un apprentissage par un procédé deep learning de la couche (42) de neurones d'entrée jusqu'à une couche (43n) de neurones intermédiaire, mise directement avant la couche (45) de neurones de sortie ; et
- par le deuxième stade du procédé d'apprentissage, on fait subir à la structure du réseau (40) neuronal un apprentissage par un procédé reinforcement learning, de la couche (43n) de neurones intermédiaire, mise directement avant la couche (45) de neurones de sortie, à la couche (45) de neurones de sortie.

13. Procédé suivant l'une des revendications 9 ou 10,
**caractérisé en ce que**
- pour un dispositif (20) de protection, qui est agencé pour recevoir, en tant que dispositif de protection central, de capteurs en plusieurs points de mesure du réseau (80) d'alimentation en énergie, des valeurs de mesure et pour commander des dispositifs de coupure en plusieurs points du réseau (80) d'alimentation en énergie, on fait subir au réseau (40) neuronal, avant l'enregistrement du contrôle, par un procédé d'apprentissage en un seul stade, un apprentissage pour le classement d'états de fonctionnement du réseau (80) d'alimentation en énergie.
